# EUROPEAN PATENT APPLICATION

(11) **EP 4 701 077 A1**
(43) Date of publication of application: **25.02.2026**
(21) Application number: 25195935.9
(22) Date of filing: 14.08.2025
(51) Int. Cl.: H03H 7/01, H03H 7/06, H03H 7/09, H03H 7/38, H03H 7/42

(54) **GAIN EQUALIZATION FOR AN IMPEDANCE MATCHING NETWORK**

(30) Priority: 19.08.2024 US 202418808955; 19.08.2024 US 202418809013
(71) Applicant: Apple Inc., Cupertino, CA 95014 (US)
(72) Inventor: DARVISHI, Milad, Cupertino, 95014 (US); MALLADI, Venkata Naga Koushik, Cupertino, 95014 (US); MOHAMMADNEZHAD, Seyed Mohammad, Cupertino, 95014 (US); PARSA, Ali, Cupertino, 95014 (US)
(74) Representative: Froud, Christopher Andrew

(57) **Abstract**

An electronic device (10) may include wireless circuitry (24) having a first circuit (60), a second circuit (62), and an impedance matching network (50) coupled between the first and second circuits (60, 62). The impedance matching network (50) can include a transformer (70) having a primary coil (72p) and a secondary coil (72s) and a first feedforward resistor (94) having a first terminal coupled to the primary coil (72p) and having a second terminal coupled to the secondary coil (72s). The impedance matching network (50) can further include a second feedforward resistor (96) coupled between the primary coil (72p) and the secondary coil (72s). The first and second feedforward resistors (94, 96) can be configured to provide a flat passband gain response for the impedance matching network (50).

## Description

This application claims priority to U.S. patent application No. 18/808,955, filed August 19, 2024, and U.S. patent application No. 18/809,013, filed August 19, 2024.

### Field

This disclosure relates generally to electronic devices, including electronic devices with wireless circuitry.

### Background

Electronic devices are often provided with wireless capabilities. An electronic device with wireless capabilities has wireless circuitry that includes one or more antennas. A transmitter in the wireless circuitry uses the antennas to transmit wireless signals. A receiver in the wireless circuitry receives wireless signals from the antennas.

The wireless circuitry can include matching networks for providing impedance matching between different circuit components. It can be challenging to design an impedance matching network. A conventional impedance matching network can exhibit gain variation across a range of frequencies. It is within such context that the embodiments herein arise.

### Summary

An aspect of the disclosure provides wireless circuitry that includes a first circuit, a second circuit, and an impedance matching network coupled between the first and second circuits, where the impedance matching network includes a transformer having a primary coil and a secondary coil and a first feedforward resistor having a first terminal coupled to the primary coil and having a second terminal coupled to the secondary coil. The primary coil can have a center tap coupled to a first voltage line, whereas the secondary coil can have a center tap coupled to a second voltage line different than the first voltage line. The impedance matching network can further include a first feedforward capacitor coupled in series with the first feedforward resistor between the primary coil and the secondary coil, a second feedforward resistor, different than the first feedforward resistor, having a first terminal coupled to the primary coil and having a second terminal coupled to the secondary coil, and a second feedforward capacitor coupled in series with the second feedforward resistor between the primary coil and the secondary coil. The impedance matching network can be configured to provide a bandpass frequency profile with a flat gain response across a range of frequencies. The first feedback resistor can be implemented using one or more transistors biased in a deep triode mode.

An aspect of the disclosure provides an impedance matching network that includes a first coil, a second coil magnetically coupled to the first coil, a first capacitor coupled across first and second opposing terminals of the first coil, a second capacitor coupled across first and second opposing terminals of the second coil, and a first feedforward resistor having a first terminal coupled to the first terminal of the first coil and having a second terminal coupled to the first terminal of the second coil. The impedance matching network can further include a second feedforward resistor having a first terminal coupled to the second terminal of the first coil and having a second terminal coupled to the second terminal of the second coil.

An aspect of the disclosure provides circuitry that includes a primary coil configured to receive a first direct current (DC) voltage, a secondary coil magnetically coupled to the primary coil and configured to receive a second direct current (DC) voltage different than the first DC voltage, a decoupling capacitor coupled between the primary coil and the secondary coil, and a feedforward resistor coupled in series with the decoupling capacitor between the primary coil and the secondary coil.

An aspect of the disclosure provides wireless circuitry that includes a first circuit, a second circuit configured to receive signals from the first circuit, and a matching network configured to provide impedance matching between the first and second circuits, where the matching network includes a transformer having a primary coil and a secondary coil and a first resistor coupled between the primary coil and the secondary coil and configured to mitigate gain peaking in a passband of the matching network. The matching network can further include a capacitor coupled in series with the first resistor between the primary coil and the secondary coil, a second resistor coupled between the primary coil and the secondary coil and configured to mitigate gain peaking in the passband of the matching network, and another capacitor coupled in series with the second resistor between the primary coil and the secondary coil. The passband of the matching network can have a gain response that is a function of a resistance of the first resistor. Only a portion of the passband of the matching network can have a gain response that is a function of a resistance of the first resistor.

The first resistor can be implemented as a polysilicon resistor, one or more transistors biased in a deep triode mode, or a transistor having a gate terminal configured to receive an adjustable voltage. In another embodiment, the first resistor can optionally include a transistor, a first capacitor coupled to a source terminal of the transistor, a second capacitor coupled to a drain terminal of the transistor, a first resistor having a first terminal coupled to the source terminal and having a second terminal configured to receive a source voltage, and a second resistor having a first terminal coupled to the drain terminal and having a second terminal configured to receive the source voltage. In another embodiment, the first resistor can optionally include a chain of transistors configured to receive a common gate voltage, a first capacitor coupled to a first end of the chain, a second capacitor coupled to a second end of the chain, a first resistor having a first terminal coupled to the first end of the chain and having a second terminal configured to receive a source voltage, and a second resistor having a first terminal coupled to the second end of the chain and having a second terminal configured to receive the source voltage.

An aspect of the disclosure provides a matching network that includes a primary coil, a secondary coil magnetically coupled to the primary coil, a feedforward path that couples the primary coil to the secondary coil, and a resistor disposed along the feedforward path, wherein the feedforward path has an impedance that is dominated by the resistor. The matching network can further include a capacitor disposed along the feedforward path, an additional feedforward path, different than the feedforward path, that couples the primary coil to the secondary coil, an additional resistor disposed along the additional feedforward path, and an additional capacitor disposed along the additional feedforward path, wherein the additional feedforward path has an impedance that is dominated by the additional resistor and not the additional capacitor.

An aspect of the disclosure provides a matching network that includes a first coil, a second coil magnetically coupled to the first coil, a feedforward path that couples the first coil to the second coil, and a resistor disposed along the feedforward path, wherein the matching network has a passband frequency response that is based on a resistance of the resistor. The resistance of the resistor can have a value configured to mitigate gain peaking or gain drooping in the passband frequency response.

### Brief Description of the Drawings

FIG. 1 is a diagram of an illustrative electronic device having wireless circuitry in accordance with some embodiments.
FIG. 2 is a diagram of illustrative wireless circuitry having one or more matching networks in accordance with some embodiments.
FIG. 3 is a circuit diagram of an illustrative matching network with capacitive and resistive coupling in accordance with some embodiments.
FIG. 4 is a plot illustrating forward transmission as a function of frequency in accordance with some embodiments.
FIG. 5 is a plot illustrating forward transmission profiles corresponding to different coupling resistance values in accordance with some embodiments.
FIGS. 6-9 illustrate various embodiments of a resistive coupling component in accordance with some embodiments.

### Detailed Description

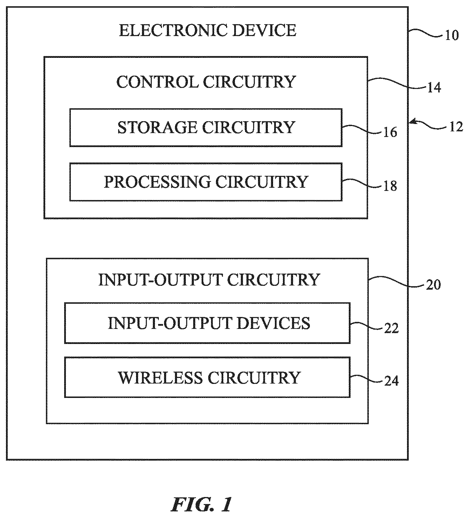

An electronic device such as an electronic device 10 of FIG. 1 may include an impedance matching network. The impedance matching network may include a transformer having a primary coil and a secondary coil. The impedance matching network may further include one or more coupling paths coupled between the primary coil and the secondary coil. Each of the coupling paths can include a resistive component and a capacitor coupled together in series. The resistive component can be implemented as a resistor or one or more switches connected together in a chain. An impedance matching network configured in this way can be technically advantageous and beneficial to provide a bandpass response with minimal gain peaking or droop (e.g., to equalize the gain in a passband frequency response of the matching network).

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more microprocessors, microcontrollers, digital signal processors, host processors, baseband processor integrated circuits, application specific integrated circuits, central processing units (CPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 5G protocols, etc.), antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), cellular sidebands, 6G bands between 100-1000 GHz (e.g., sub-THz, THz, or THF bands), etc.), other centimeter or millimeter wave frequency bands between 10-300 GHz, near-field communications frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

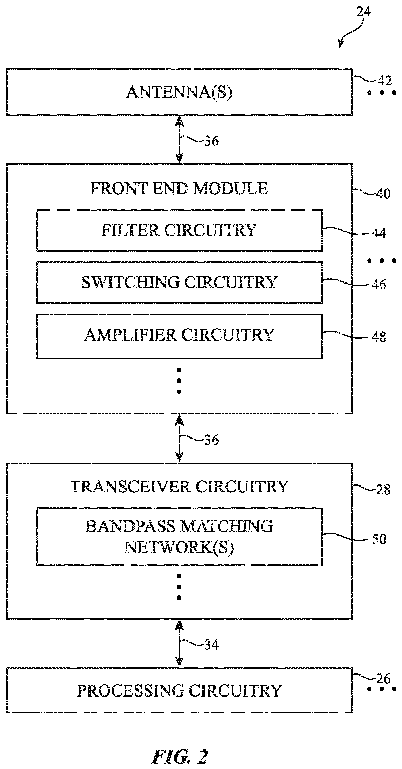

FIG. 2 is a diagram showing illustrative components within wireless circuitry 24. As shown in FIG. 2, wireless circuitry 24 may include processing circuitry 26, radio-frequency (RF) transceiver circuitry such as radio-frequency transceiver 28, radio-frequency front end circuitry such as radio-frequency front end module (FEM) 40, and antenna(s) 42. Processing circuitry 26 may include a baseband processor, an application processor, a digital signal processor, a microcontroller, a microprocessor, a central processing unit (CPU), a programmable device, a combination of these circuits, and/or one or more processors within circuitry 18. Processing circuitry 26 may be configured to generated digital (baseband) signals.

In the example of FIG. 2, wireless circuitry 24 is illustrated as including only a single processing unit 26, a single transceiver 28, a single front end module 40, and a single antenna 42 for the sake of clarity. In general, wireless circuitry 24 may include any desired number of processing units 26, any desired number of transceivers 36, any desired number of front end modules 40, and any desired number of antennas 42. Each processing unit 26 may be coupled to one or more transceivers 28 over respective baseband paths 34. Each transceiver 28 may include a transmitter circuit configured to output uplink signals to antenna 42, may include a receiver circuit configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module.

Processing circuitry 26 may be coupled to transceiver 28 over baseband path 34. Transceiver 28 may be coupled to antenna 42 via radio-frequency transmission line path 36. Radio-frequency front end module 40 may be disposed on radio-frequency transmission line path 36 between transceiver 28 and antenna 42. Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards.

Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

Front end module (FEM) 40 may include radio-frequency front end circuitry that operates on the radio-frequency signals conveyed (transmitted and/or received) over radio-frequency transmission line path 36. Front end module 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifiers and one or more low-noise amplifiers), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip or on separate integrated circuit chips.

Filter circuitry 44, switching circuitry 46, amplifier circuitry 48, and other circuitry may be disposed on radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processing circuitry 26 and/or portions of transceiver 28 (e.g., a host processor on transceiver 28) may form a part of control circuitry 14. Control circuitry 14 (e.g., portions of control circuitry 14 formed on processing circuitry 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver circuitry 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio (NR) Frequency Range 1 (FR1) bands below 10 GHz, 5G New Radio Frequency Range 2 (FR2) bands between 20 and 60 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

In performing wireless transmission, processing circuitry 26 may provide baseband signals to transceiver 28 over baseband path 34. Transceiver 28 may further include circuitry for converting the baseband signals received from baseband processing circuitry 26 into corresponding radio-frequency signals. For example, transceiver circuitry 28 may include mixer circuitry for up-converting (or modulating) the baseband signals to intermediate frequencies or radio frequencies prior to transmission over antenna 42. Transceiver circuitry 28 may also include digital-to-analog converter (DAC) and/or analog-to-digital converter (ADC) circuitry for converting signals between digital and analog domains. Transceiver 28 may include a transmitter component to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from external wireless equipment. The received radio-frequency signals may be conveyed to transceiver 28 via radio-frequency transmission line path 36 and front end module 40. Transceiver 28 may include circuitry for converting the received radio-frequency signals into corresponding baseband signals. For example, transceiver 28 may employ mixer circuitry for down-converting (or demodulating) the received radio-frequency signals to intermediate frequencies or baseband frequencies prior to conveying the received signals to processing circuitry 26 over baseband path 34.

In accordance with some embodiments, transceiver circuitry 28 may further include one or more matching networks such as matching networks 50. At least some of the matching networks 50 can be considered bandpass matching networks. A "bandpass" matching network 50 can refer to and be defined herein as a matching network configured to provide impedance matching between two different circuit components over a given range of frequencies (e.g., across one or more frequency bands), thus allowing signals within the given frequency range to pass through (e.g., with some signal gain or minimal signal attenuation) while attenuating or rejecting signals outside that frequency range. Although FIG. 2 shows bandpass matching network(s) 50 being included as part of transceiver circuitry 28, one or more bandpass matching networks 50 can additionally or alternatively be included as part of front end module 40 and/or can otherwise be coupled to antenna(s) 42.

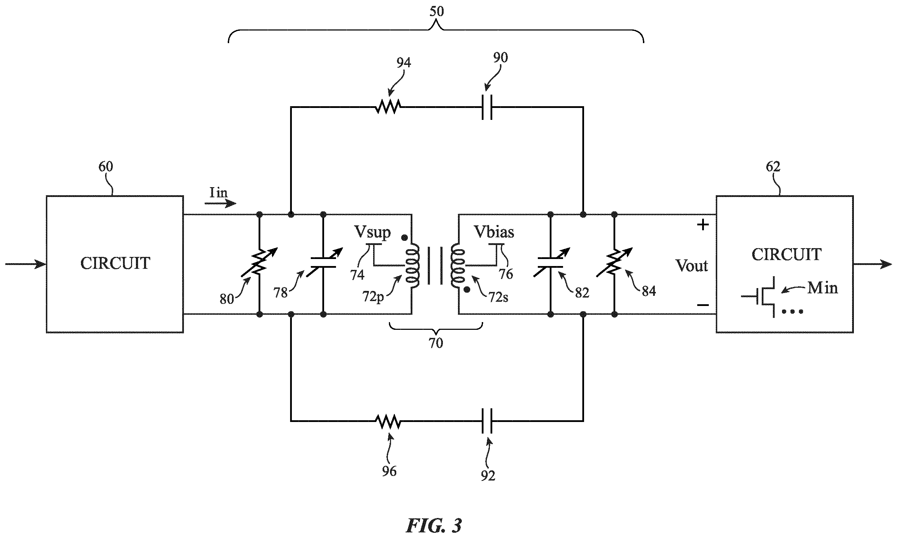

FIG. 3 is a circuit diagram of an illustrative matching network 50. As shown in FIG. 3, matching network 50 can be coupled between a first circuit 60 and a second circuit 62 and can be configured to provide impedance matching between circuits 60 and 62. Circuit 62 may, for example, include one or more input transistors Min having a gate terminal coupled to matching network 50. In the example of FIG. 3, circuit 60 may have an output that is coupled to an input of matching network 50, whereas circuit 62 may have an input (e.g., one or more gate terminals of input transistor(s) Min) coupled to an output of matching network 50. In certain embodiments, matching circuit 50 can receive at its input an input current Iin from the output of circuit 60 and can provide at its output an output voltage Vout to the input of circuit 62. Circuits 60 and 62 can generally represent any circuit components within transceiver circuitry 28 (see FIG. 2), front end module 40, wireless circuitry 24, or control circuitry 14 (see FIG. 1).

Matching network 50 can include a transformer such as transformer 70. Matching network 50 that includes transformer 70 can sometimes be referred to as a transformer based impedance matching circuit. Transformer 70 may include a primary coil (winding) 72p and a secondary coil (winding) 72s. The secondary coil 72s may be magnetically coupled to the primary coil 72p, or vice versa. Primary coil 72p can have a center tap terminal coupled to a voltage line such as power supply line 74 (e.g., a power supply terminal on which power supply voltage Vsup is provided). Voltage Vsup can represent a positive power supply voltage or other high voltage. A capacitor such as capacitor 78 can be coupled across the two opposing terminals of primary coil 72p (e.g., capacitor 78 may be coupled in parallel with coil 72p). Capacitor 78 can be an adjustable capacitor implemented as a bank of switchable capacitors (e.g., an array of capacitors each of which is selectively activated by a respective switch), a variable capacitor sometimes referred to as a varactor, a varicap diode, a metal-oxide-semiconductor capacitor (MOSCAP), and/or other components configured to provide a variable capacitance. A resistor such as resistor 80 can also be coupled across the two opposing terminals of primary coil 72p (e.g., resistor 80 may be coupled in parallel with coil 72p and adjustable capacitor 78). Resistor 80 can be an adjustable resistor implemented as a bank of switchable resistors (e.g., an array of resistors each of which is selectively activated by a respective switch), a resistive ladder, a variable resistor (e.g., a digitally controlled resistor), one or more transistors, and/or other components configured to provide a variable resistance.

On the other end, secondary coil 72s can have a center tap terminal coupled to a voltage line such as bias voltage line 76 (e.g., a bias terminal on which bias voltage Vbias is provided). Voltage Vbias can be equal to supply voltage Vsup, can be less than Vsup, can be equal to a ground voltage Vss, or can be an intermediate voltage between Vsup and Vss. A capacitor such as capacitor 82 can be coupled across the two opposing terminals of secondary coil 72s (e.g., capacitor 82 may be coupled in parallel with coil 72s). Capacitor 82 can be an adjustable capacitor implemented as a bank of switchable capacitors (e.g., an array of capacitors each of which is selectively activated by a respective switch), a variable capacitor sometimes referred to as a varactor, a varicap diode, a metal-oxide-semiconductor capacitor (MOSCAP), and/or other components configured to provide a variable capacitance. A resistor such as resistor 84 can also be coupled across the two opposing terminals of secondary coil 72s (e.g., resistor 84 may be coupled in parallel with coil 72s and adjustable capacitor 82). Resistor 84 can be an adjustable resistor implemented as a bank of switchable resistors (e.g., an array of resistors each of which is selectively activated by a respective switch), a resistive ladder, a variable resistor (e.g., a digitally controlled resistor), one or more transistors, and/or other components configured to provide a variable resistance.

Matching network 50 can further include a capacitor 90 and a capacitor 92. Capacitor 90 may be coupled between a first terminal of primary coil 72p and a first terminal of secondary coil 72s. Capacitor 92 may be coupled between a second terminal, opposing the first terminal, of primary coil 72p and a second terminal, opposing the first terminal, of secondary coil 72s. Capacitors 90 and 92 coupled across the primary and secondary coils of transformer 70 are sometimes referred to as feedforward capacitors. Capacitors 90 and 92 can each be implemented as a metal-oxide-semiconductor (MOS) capacitor, a metal-insulator-metal (MIM) capacitor, a metal-oxide-metal (MOM) capacitor, a polysilicon-insulator-polysilicon (PIP) capacitor, a trench capacitor (e.g., a capacitor formed by filling a trench with conductive and high-k dielectric material), and/or other types of integrated capacitors.

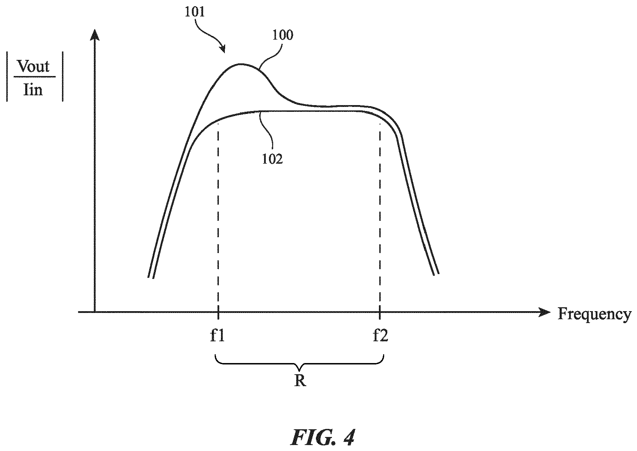

FIG. 4 is a plot illustrating forward transmission as a function of frequency. Forward transmission may refer to herein as the ratio of the output voltage Vout of matching network 50 to the input current Iin of matching network. Such forward transmission is sometimes referred to as a "Z₂₁" parameter. As shown in FIG. 4, curve 100 may represent the forward transmission profile of a matching network that includes only capacitors in the feedforward paths (i.e., where the feedforward paths include capacitors 90 and 92 but do not include resistors 94 and 96). Curve 100 can exhibit a bandpass response that passes signals in a frequency range R from frequency f1 to frequency f2. The use of only capacitors in the feedforward paths might produce a desired flat gain response near the upper portion of the frequency range R (near or below frequency f2) but can still exhibit undesired gain peaking 101 near the lower portion of frequency range R (near or above frequency f1). Moreover, any variation of the feedforward capacitance across different process corners can lead to significant uncertainty in the overall shape of the bandpass response curve 100. Techniques for trimming the feedforward capacitors to compensate for process variations can be cumbersome. The example of FIG. 4 in which curve 100 exhibits gain peaking 101 is illustrative. Curve 100 associated with a matching network with only capacitive feedforward paths can alternatively exhibit undesired gain droop - another undesired phenomenon in which the forward transmission drops below the target (flat) gain level.

Referring back to FIG. 3, matching network 50 can be further provided with resistors 94 and 96 in the feedforward paths. As shown in FIG. 3, resistor 94 may be coupled in series with capacitor 90 between the first terminal of primary coil 72p and the first terminal of secondary coil 72s. At the other end, resistor 96 may be coupled in series with capacitor 92 between the second terminal of primary coil 72p and the second terminal of secondary coil 72s. Resistors 94 and 96 disposed along the feedforward paths can thus sometimes be referred to herein as feedforward resistors. The example of FIG. 3 in which feedforward resistor 94 is coupled between the coil 72p and capacitor 90 is illustrative. If desired, the positions of resistor 94 and capacitor 90 can be swapped (e.g., resistor 94 can alternatively be coupled between capacitor 90 and the first terminal of coil 72s). Similarly, the positions of resistor 96 and capacitor 92 can also be swapped (e.g., feedforward resistor 96 can alternatively be coupled between capacitor 92 and the second terminal of coil 72s).

In FIG. 4, curve 102 may represent the forward transmission profile of matching network 50 that includes resistors 94 and 96 in the feedforward paths. As shown in FIG. 4, curve 102 can exhibit a bandpass response that passes signals in frequency range R from frequency f1 to frequency f2. Unlike curve 100, which exhibits undesired gain peaking within the passband, curve 102 exhibits a relatively flat gain response. The use of feedforward resistors 94 and 96 can thus be technically advantageous and beneficial to help suppress undesired gain peaking (or drooping, if present) in the passband of matching network 50. In the example of FIG. 4, the use of feedforward resistors 94 and 96 can selectively reducing the gain peaking near the lower portion of frequency range R (e.g., only the lower portion of the passband is a function of a resistance of the feedforward resistors). The feedforward capacitors 90 and 92 can help serve as DC (direct current) decoupling capacitors for isolating separate DC voltages that may be present on the two sides of transformer 70. Capacitors 90 and 92 are therefore sometimes referred to herein as DC decoupling capacitors. If the DC voltages at the primary side and the secondary side of transformer 70 are equal, then capacitors 90 and 92 can optionally be omitted to save area and cost.

Matching network 50 can be a symmetric or an asymmetric matching network. A "symmetric" matching network 50 can refer to an arrangement where the inductance of primary coil 72p and second coil 72p are equal, where the capacitance of capacitor 78 at the primary side and the capacitance of capacitor 82 at the secondary side are equal, and where the resistance of resistor 80 at the primary side and the resistance of resistor 84 at the secondary side are equal. In contrast, an "asymmetric" matching network 50 can refer to an arrangement where the inductances of primary coil 72p and second coil 72p are unequal (mismatched), where the capacitance of capacitor 78 at the primary side and the capacitance of capacitor 82 at the secondary side are unequal, and where the resistance of resistor 80 at the primary side and the resistance of resistor 84 at the secondary side are unequal. Whether matching network 50 is symmetric or asymmetric, the feedforward resistors 94 can help provide a flat passband (bandpass) gain response with minimal peaking or drooping.

The example of FIG. 3 in which matching network 50 is a differential matching network is illustrative. In other embodiments, matching network 50 can be a single-ended impedance matching network. In a single-ended configuration, the second terminal of the primary coil 72p (e.g., the bottom terminal of winding 72p shown in the orientation of FIG. 3) can be shorted to a ground power supply line, and second terminal of the secondary coil 72s (e.g., the bottom terminal of winding 72s) can also be shorted to the ground power supply line. In the single-ended configuration, resistor 96 and capacitor 92 can be omitted, and the feedforward resistor 94 can be coupled between the first terminal of primary coil 72p (e.g., the top terminal of winding 72p in the orientation of FIG. 3) and the first terminal of secondary coil 72s (e.g., the top terminal of winding 72s). Feedforward capacitor 90 can optionally be coupled in series with resistor 94 in the feedforward path. Such type of single-ended matching network 50 with a feedforward resistor can also provide a flat passband gain response with minimal peaking or drooping.

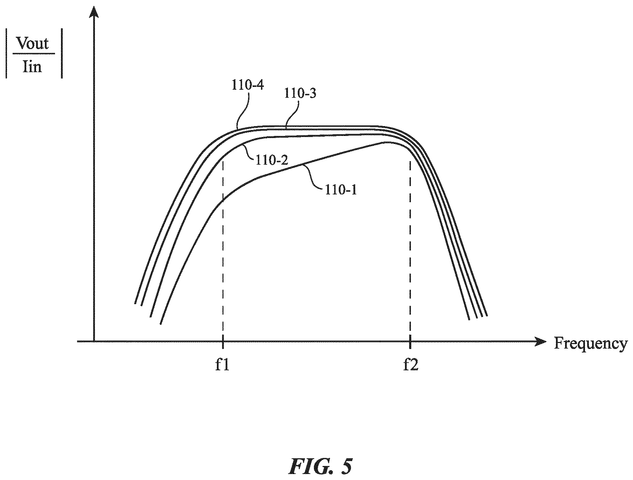

FIG. 5 is a plot illustrating forward transmission profiles as a function of frequency corresponding to different resistance values of the feedforward resistors. Curve 110-1 may represent a first passband response for matching network 50 if the feedforward resistors have a first resistance value. Curve 110-2 may represent a second passband response for matching network 50 if the feedforward resistors have a second resistance value greater than the first resistance value. Curve 110-3 may represent a third passband response for matching network 50 if the feedforward resistors have a third resistance value greater than the second resistance value. Curve 110-4 may represent a fourth passband response for matching network 50 if the feedforward resistors have a fourth resistance value greater than the third resistance value.

As illustrated by FIG. 5, higher feedforward resistance values can generally produce a flatter passband gain response within the target frequency range. Thus, as examples, the resistance of each of the feedforward resistors can be greater than one thousand ohms, 1000-5000 ohms, greater than 5000 ohms, greater than 6000 ohms, greater than 7000 ohms, greater than 8000 ohms, greater than 9000 ohms, 5000-9000 ohms, or greater than ten thousands ohms. Having a relatively high feedforward resistance value as described above for the feedforward resistors allows the impedance of the feedforward paths to be dominated by the feedforward resistors and not by the feedforward capacitors or other parasitic loading. As a result, the parasitic inductance and/or resistance of the feedforward path itself for connecting to the feedforward resistors are not a concern. Moreover, any potential mismatch of the feedforward capacitors (if present) due to process variation would similarly be inconsequential in the presence of large feedforward resistors. If desired, the feedforward resistors 94 and 96 may be adjustable resistors, each of which can be implemented as a bank of switchable resistors (e.g., an array of resistors each of which is selectively activated by a respective switch), a resistive ladder, a variable resistor (e.g., a digitally controlled resistor), one or more transistors coupled together in parallel and/or in series, and/or other components configured to provide a variable resistance.

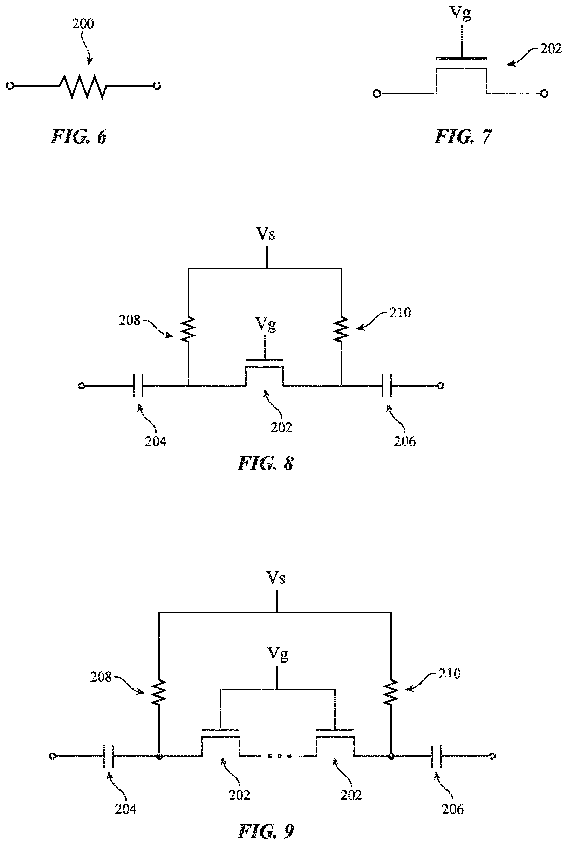

Each of the feedforward resistors 94 and 96 can be implemented in various ways. FIG. 6 shows one embodiment of a feedforward resistor implemented as an explicit resistor 200 such as a polysilicon resistor in an integrated circuit. FIG. 7 shows another embodiment of a feedforward resistor implemented as a transistor 202. In accordance with an embodiment, transistor 202 can be a n-type metal-oxide-semiconductor (NMOS) transistor having a gate terminal configured to receive a gate voltage Vg configured to bias transistor 202 in a deep triode mode, sometimes also referred to as a linear operating mode. A transistor 202 operating in the deep triode mode can be configured to behave like a variable resistor. Gate voltage Vg can be dynamically adjusted to control the passband gain of the overall matching network 50 as well as compensate for variation of transformer 70 across process and/or temperature variations.

FIG. 8 shows another embodiment of a feedforward resistor implemented using a single transistor 202 and various passive components. As shown in FIG. 8, transistor 202 may be an NMOS transistor have a gate terminal configured to receive gate voltage Vg, a source terminal coupled to capacitor 204, and a drain terminal coupled to capacitor 206. A source voltage Vs can be electrically coupled to the source terminal of transistor 202 via resistor 208 and to the drain terminal of transistor 202 via resistor 210. Capacitors 204 and 206 can be configured as DC-voltage-blocking capacitors (e.g., serving as open circuits for DC voltage signals), which allows the gate-to-source voltage of transistor 202 to be set equal to Vg minus Vs. As an example, the source voltage Vs can be biased to 0 V or other ground voltage, whereas the gate voltage Vg can be set equal to Vsup or other positive power supply voltage. The feedforward resistor of FIG. 8 that includes multiple components such as transistor 202, capacitors 204 and 206, and resistors 208 and 210 can thus sometimes be referred to collectively as a feedforward resistive circuit.

The terms "source" and "drain" are sometimes used interchangeably when referring to current-conducting terminals of a metal-oxide-semiconductor transistor. The source and drain terminals are therefore sometimes referred to as "source-drain" terminals (e.g., a transistor has a gate terminal, a first source-drain terminal, and a second source-drain terminal). The term "activate" with respect to a switch (or transistor) may refer to or be defined herein as an action that places the switch in an "on" or low-impedance state such that the two terminals of the switch are electrically connected to conduct current. Activating a switch can sometimes be referred to as turning on or closing a switch. The term "deactivate" with respect to a switch (or transistor) may refer to or be defined herein as an action that places the switch in an "off" or high-impedance state such that the two terminals of the switch/transistor are electrically disconnected with minimal leakage current. Deactivating a switch can sometimes be referred to as turning off or opening a switch.

The example of FIG. 8 in which the feedforward resistive circuit includes a single transistor 202 is illustrative. In general, the feedforward resistive circuit can include one or more switches/transistors. FIG. 9 shows another embodiment of a feedforward resistor implemented using multiple transistors 202 and various passive components. As shown in FIG. 9, the multiple transistors 202 may be NMOS transistors coupled together in a chain and having gate terminals configured to receive common gate voltage Vg (e.g., all transistors 202 in the chain have gate terminals that receive the same gate voltage Vg), source terminals coupled to capacitor 204, and drain terminals coupled to capacitor 206. The remaining structure and function of the feedforward resistive circuit of FIG. 9 is similar to that already described above in connection with FIG. 8 and need not be reiterated in order to avoid obscuring the present embodiment. Connecting multiple transistors 202 in series in this way can be technically advantageous and beneficial to improve the linearity of the overall matching network 50.

The example of FIGS. 7-9 in which the transistor(s) 202 are MOS transistors is illustrative. In other embodiments, the one or more transistors 202 can be implemented as bipolar junction transistors (BJTs), insulated-gate bipolar transistors (IGBTs), junction field-effect transistors (JFETs), tunnel field-effect transistors (TFETs), fin field-effect transistors (FinFETs), silicon-on-insulator (SOI) transistors, carbon nanotube transistors, nanowire transistors, a combination of these transistors, and/or other types of transistors.

The methods and operations described above in connection with FIGS. 1-9 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry 26 in wireless circuitry 24, processing circuitry 18 of FIG. 1, etc.). The processing circuitry 26 may include microprocessors, application processors, digital signal processors, central processing units (CPUs), application-specific integrated circuits with processing circuitry, or other processing circuitry.

In accordance with an aspect of the invention, wireless circuitry includes a first circuit, a second circuit, and an impedance matching network coupled between the first and second circuits, where the impedance matching network includes a transformer having a primary coil and a secondary coil and further includes a first feedforward resistor having a first terminal coupled to the primary coil and having a second terminal coupled to the secondary coil.

The primary coil optionally has a center tap coupled to a first voltage line.

The secondary coil optionally has a center tap coupled to a second voltage line different than the first voltage line.

The impedance matching network optionally includes an adjustable capacitor coupled across opposing terminals of the primary coil.

The impedance matching network optionally includes an adjustable resistor coupled across the opposing terminals of the primary coil.

The impedance matching network optionally includes an adjustable capacitor coupled across opposing terminals of the secondary coil.

The impedance matching network optionally includes an adjustable resistor coupled across the opposing terminals of the secondary coil.

The impedance matching network optionally includes a first feedforward capacitor coupled between the first feedforward resistor and the secondary coil.

The impedance matching network optionally includes a first feedforward capacitor coupled between the primary coil and the first feedforward resistor.

The impedance matching network optionally includes a second feedforward resistor, different than the first feedforward resistor, having a first terminal coupled to the primary coil and having a second terminal coupled to the secondary coil.

The impedance matching network optionally includes a second feedforward capacitor coupled in series with the second feedforward resistor between the primary coil and the secondary coil.

The first feedforward resistor is optionally coupled between a first terminal of the primary coil and a first terminal of the secondary coil, and the second feedforward resistor is coupled between a second terminal, opposing the first terminal, of the primary coil and a second terminal, opposing the first terminal, of the secondary coil.

The impedance matching network is optionally configured to provide a bandpass frequency profile with a flat gain response across a range of frequencies.

The primary coil optionally has a first inductance, and the secondary coil optionally has a second inductance equal to the first inductance.

The primary coil optionally has a first inductance, and the secondary coil optionally has a second inductance different than the first inductance.

The first feedback resistor optionally includes one or more transistors.

The one or more transistors of the first feedback resistor are optionally biased in a deep triode mode.

In accordance with an aspect of the invention, an impedance matching network includes a first coil, a second coil magnetically coupled to the first coil, a first capacitor coupled across first and second opposing terminals of the first coil, a second capacitor coupled across first and second opposing terminals of the second coil, and a first feedforward resistor having a first terminal coupled to the first terminal of the first coil and having a second terminal coupled to the first terminal of the second coil.

The impedance matching network optionally includes a second feedforward resistor having a first terminal coupled to the second terminal of the first coil and having a second terminal coupled to the second terminal of the second coil.

In accordance with an aspect of the invention, circuitry includes a primary coil configured to receive a first direct current (DC) voltage, a secondary coil magnetically coupled to the primary coil and configured to receive a second direct current (DC) voltage different than the first DC voltage, a decoupling capacitor coupled between the primary coil and the secondary coil, and a feedforward resistor coupled in series with the decoupling capacitor between the primary coil and the secondary coil.

In accordance with an aspect of the invention, wireless circuitry includes a first circuit, a second circuit configured to receive signals from the first circuit, and a matching network configured to provide impedance matching between the first and second circuits, where the matching network includes a transformer having a primary coil and a secondary coil and further includes a first resistor coupled between the primary coil and the secondary coil and configured to mitigate gain peaking in a passband of the matching network.

The matching network optionally includes a capacitor coupled in series with the first resistor between the primary coil and the secondary coil.

In accordance with another embodiment, the matching network optionally includes a second resistor coupled between the primary coil and the secondary coil and configured to mitigate gain peaking in the passband of the matching network.

The matching network optionally includes a capacitor coupled in series with the second resistor between the primary coil and the secondary coil.

The wireless circuitry optionally includes an adjustable capacitor coupled across opposing terminals of the primary coil and an adjustable resistor coupled across the opposing terminals of the primary coil.

The wireless circuitry optionally includes an adjustable capacitor coupled across opposing terminals of the secondary coil and an adjustable resistor coupled across the opposing terminals of the secondary coil.

The first resistor optionally includes a polysilicon resistor.

The first resistor optionally includes one or more transistors biased in a deep triode mode.

The first resistor optionally includes a transistor having a gate terminal configured to receive an adjustable voltage.

The first resistor optionally includes a transistor, a first capacitor coupled to a source terminal of the transistor, a second capacitor coupled to a drain terminal of the transistor, a first resistor having a first terminal coupled to the source terminal and having a second terminal configured to receive a source voltage, and a second resistor having a first terminal coupled to the drain terminal and having a second terminal configured to receive the source voltage.

The first resistor optionally includes a chain of transistors configured to receive a common gate voltage, a first capacitor coupled to a first end of the chain, a second capacitor coupled to a second end of the chain, a first resistor having a first terminal coupled to the first end of the chain and having a second terminal configured to receive a source voltage, and a second resistor having a first terminal coupled to the second end of the chain and having a second terminal configured to receive the source voltage.

The primary coil optionally has a center tap coupled to a first voltage line, and the secondary coil has a center tap coupled to a second voltage line different than the first voltage line.

The passband of the matching network optionally has a gain response that is a function of a resistance of the first resistor.

Only a portion of the passband of the matching network optionally has a gain response that is a function of a resistance of the first resistor.

The first resistor is optionally disposed along a feedforward path coupling the primary coil to the secondary coil, where the feedforward path includes an electrical component coupled in series with the first resistor, and an impedance of the feedforward path is optionally dominated by the first resistor and not the electrical component.

In accordance with an aspect of the invention, a matching network includes a primary coil, a secondary coil magnetically coupled to the primary coil, a feedforward path that couples the primary coil to the secondary coil, and a resistor disposed along the feedforward path, where the feedforward path has an impedance that is dominated by the resistor.

The matching network optionally includes a capacitor disposed along the feedforward path.

The matching network optionally includes: an additional feedforward path, different than the feedforward path, that couples the primary coil to the secondary coil; an additional resistor disposed along the additional feedforward path; and an additional capacitor disposed along the additional feedforward path, where the additional feedforward path has an impedance that is dominated by the additional resistor and not the additional capacitor.

In accordance with an aspect of the invention, a matching network includes a first coil, a second coil magnetically coupled to the first coil, a feedforward path that couples the first coil to the second coil, and a resistor disposed along the feedforward path, where the matching network has a passband frequency response that is based on a resistance of the resistor.

The resistance of the resistor optionally has a value configured to mitigate gain peaking or gain drooping in the passband frequency response.

The foregoing is merely illustrative and various modifications can be made to the described embodiments. The foregoing embodiments may be implemented individually or in any combination.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

## Claims

1. Wireless circuitry comprising:
a first circuit;
a second circuit; and
an impedance matching network coupled between the first and second circuits, wherein the impedance matching network comprises:
a transformer having a primary coil and a secondary coil; and
a first feedforward resistor having a first terminal coupled to the primary coil and having a second terminal coupled to the secondary coil.

2. The wireless circuitry of claim 1, wherein the primary coil has a center tap coupled to a first voltage line.

3. The wireless circuitry of claim 2, wherein the secondary coil has a center tap coupled to a second voltage line different than the first voltage line.

4. The wireless circuitry of any preceding claim, wherein the impedance matching network further comprises:
an adjustable capacitor coupled across opposing terminals of the primary coil.

5. The wireless circuitry of claim 4, wherein the impedance matching network further comprises:
an adjustable resistor coupled across the opposing terminals of the primary coil.

6. The wireless circuitry of any preceding claim, wherein the impedance matching network further comprises:
an adjustable capacitor coupled across opposing terminals of the secondary coil.

7. The wireless circuitry of claim 6, wherein the impedance matching network further comprises:
an adjustable resistor coupled across the opposing terminals of the secondary coil.

8. The wireless circuitry of any preceding claim, wherein the impedance matching network further comprises:
a first feedforward capacitor (90) coupled between the first feedforward resistor (94) and the secondary coil.

9. The wireless circuitry of any of claims 1 to 7, wherein the impedance matching network further comprises:
a first feedforward capacitor coupled between the primary coil and the first feedforward resistor.

10. The wireless circuitry of any preceding claim, wherein the impedance matching network further comprises:
a second feedforward resistor, different than the first feedforward resistor, having a first terminal coupled to the primary coil and having a second terminal coupled to the secondary coil.

11. The wireless circuitry of claim 10, wherein the impedance matching network further comprises:
a second feedforward capacitor coupled in series with the second feedforward resistor between the primary coil and the secondary coil.

12. The wireless circuitry of claim 10 or claim 11, wherein:
the first feedforward resistor is coupled between a first terminal of the primary coil and a first terminal of the secondary coil; and
the second feedforward resistor is coupled between a second terminal, opposing the first terminal, of the primary coil and a second terminal, opposing the first terminal, of the secondary coil.

13. The wireless circuitry of any preceding claim, wherein the impedance matching network is configured to provide a bandpass frequency profile with a flat gain response across a range of frequencies.

14. The wireless circuitry of any preceding claim, wherein the first feedback resistor comprises one or more transistors.

15. The wireless circuitry of claim 14, wherein the one or more transistors of the first feedback resistor are biased in a deep triode mode.
